# EUROPÄISCHE PATENTSCHRIFT

(11) **EP 2 025 212 B1**
(45) Veröffentlichungstag und Bekanntmachung des Hinweises auf die Patenterteilung: **02.01.2013**
(21) Anmeldenummer: 07729125.0
(22) Anmeldetag: 15.05.2007
(51) Int. Cl.: H05K 5/02, G12B 9/08

(54) **GERÄTEGEHÄUSE, INSBESONDERE FÜR EINEN SENSOR FÜR KRAFTFAHRZEUGE**
DEVICE HOUSING IN PARTICULAR FOR A SENSOR FOR MOTOR VEHICLES
LOGEMENT POUR APPAREIL EN PARTICULIER POUR UN CAPTEUR UTILISÉ DANS UN VÉHICULE À MOTEUR

(30) Priorität: 18.05.2006 DE 102006023471
(43) Veröffentlichungstag der Anmeldung: 18.02.2009
(73) Patentinhaber: Continental Automotive GmbH, 30165 Hannover (DE)
(72) Erfinder: CHRISTOPH, Markus, 93055 Regensburg (DE); PLANKL, Christian, 93055 Burgweinting (DE)
(86) Internationale Anmeldenummer: PCT/EP2007/054673
(87) Internationale Veröffentlichungsnummer: WO 2007/135016

(56) Entgegenhaltungen:
- EP-A- 0 365 904
- WO-A-2004/097283
- DE-A1- 2 119 915
- US-A- 5 950 973

## Beschreibung

Die Erfindung betrifft ein Gehäuse für ein an einer Anbaufläche zu befestigendes Gerät, insbesondere ein Sensormodul mit einem Sensor für ein Kraftfahrzeug.

Wenn in der nachfolgenden Beschreibung auf ein Sensormodul Bezug genommen wird, so ist dies lediglich als beispielhaft zu betrachten. Die Erfindung lässt sich allgemein, unabhängig von dem Zweck des Geräts, für sämtliche an einer Anbaufläche zu befestigende Gehäuse einsetzen.

Bei der Ausgestaltung des mit elektronischen Komponenten versehenen Geräts als Sensormodul ist abhängig von der Art des eingesetzten Sensors eine lagerichtige Position des Geräts an der Anbaufläche sowie eine korrekte, funktionsfähige elektrische Kontaktierung des Geräts notwendig, um die bestimmungsgemäße Funktion gewährleisten zu können. Ein Seitenairbag-Sensormodul wird in einem Kraftfahrzeug an einem Karosseriebauteil, wie z.B. der so genannten B-Säule, einem Schweller oder einem Sitzquerträger montiert.

Die Gehäuse sind in der Regel aus einem Kunststoff gefertigt. Dies weist den Vorteil auf, dass aufgrund der einfachen Fertigung mittels eines Spritzverfahrens kundenspezifische Merkmale, wie z.B. Befestigungspunkte und Positionierzapfen zur Sicherstellung des korrekten Einbaus des Sensormoduls, vorgesehen sein können.

Gattungsgemäße Gehäuse sind bspw. in den Schriften WO 2004/097283 A, DE 21 19 915 A1 offenbart. Die Offenlegungsschrift DE 21 19 915 A1 beschreibt ein Gehäuse, das mithilfe von im Gehäuse gebildeten, die Stecker aufnehmenden Anschlusskammern und zumindest einer von außen bedienbaren Verriegelungseinrichtung die Lage der in die Kammern eingesetzten Stecker im Gehäuse sichert.

Die Lagerichtigkeit des Gerätes, welche für die korrekte Funktionsfähigkeit von essentieller Bedeutung ist, wird durch den korrekten Sitz der Schraubverbindung und den Positionierzapfen sichergestellt, wobei der Positionierzapfen in eine für diesen vorgesehene Öffnung der Anbaufläche eingesetzt werden muss. Nur wenn der Positionierzapfen in der Öffnung gelegen ist, ist eine korrekte Befestigung des Gerätes über die Schrauben an der Anbaufläche möglich. Für die Verifikation, ob der Einbau des Sensormoduls korrekt erfolgte, wird bei der Befestigung des Gehäuses mittels der Schraube(n) an der Anbaufläche das Drehmoment beim Anziehen der Schraube(n) überprüft. Dies erfolgt unter der Annahme, dass nur bei korrekt an der Anbaufläche anliegendem Gehäuse und einem korrekten Eingriff der Schraube(n) in eine entsprechende Öffnung der Anbaufläche das vorgegebene Drehmoment detektierbar ist.

In einigen Fällen ist es jedoch möglich, dass das vorgeschriebene Drehmoment der Schrauben detektierbar ist, obwohl sich das Gehäuse nicht in seiner korrekten Position befindet. Somit liegt scheinbar eine Lagerichtigkeit des an der Anbaufläche befestigten Gehäuses vor, obwohl dies tatsächlich nicht der Fall ist. Dies kann unter ungünstigen Umständen dazu führen, dass die von dem Sensor aufgenommenen Signale nicht korrekt sind. Es ist deshalb nicht auszuschließen, dass eine Steuereinheit, welche die von dem Sensor übertragenen Signale auswertet, eine Auswertung auf Basis falscher oder verfälschter Signale vornimmt. Im Falle eines Sensormoduls für einen Airbag-Satelliten könnte die "falsche" Auswerteentscheidung eine Nicht-Auslösung eines Airbags im Falle eines tatsächlichen Crashs oder eine Auslösung zum falschen Zeitpunkt usw. zur Folge haben.

Es ist Aufgabe der vorliegenden Erfindung, ein Gehäuse für ein an einer Anbaufläche zu befestigendes Gerät, insbesondere ein Sensormodul mit einem Sensor für ein Kraftfahrzeug, anzugeben, welches die oben genannten Nachteile nicht aufweist.

Diese Aufgabe wird durch ein Gehäuse mit den Merkmalen des Patentanspruches 1 gelöst. Vorteilhafte Ausführungsformen sind in den abhängigen Patentansprüchen beschrieben.

Ein erfindungsgemäßes Gehäuse für ein an einer Anbaufläche zu befestigendes Gerät, insbesondere ein Sensormodul mit einem Sensor für ein Kraftfahrzeug, weist folgende Merkmale auf:

Eine Gehäuseanbaufläche, mit welcher das Gehäuse an der Anbaufläche in Anlage bringbar ist. Einen Kontaktbecher mit elektrischen Kontaktmitteln, der mit einem komplementär ausgebildeten Kontaktstecker mechanisch und elektrisch verbindbar ist und der sich parallel zu einer Gehäuseebene erstreckt, in der die Gehäuseanbaufläche angeordnet ist. Eine Verriegelungsvorrichtung, die ein Detektionsmittel und ein Blockiermittel aufweist. Das Detektionsmittel ist dazu ausgebildet, eine vorbestimmte Position an der Anbaufläche zu detektieren, wenn das Gehäuse mit der Gehäuseanbaufläche an der Anbaufläche aufliegt. Das Blockiermittel ist dazu ausgebildet, die mechanische und/oder elektrische Verbindung zwischen dem Kontaktbecher und dem Kontaktstecker freizugeben oder zu blockieren, wobei die Verbindung durch das Blockiermittel freigegeben wird, wenn das Gehäuse mit seiner Gehäuseanbaufläche in der vorbestimmten Position an der Anbaufläche aufliegt.

Die Erfindung basiert somit auf dem Prinzip, eine mechanische und/oder elektrisch Verbindung zwischen dem Kontaktbecher und dem Kontaktstecker erst dann vornehmen zu können, wenn die lagerichtige Position des Gehäuses an der Anbaufläche vorliegt. Nimmt das Gehäuse jedoch nicht die vorbestimmte Position an der Anbaufläche ein, so wird dies bei der Montage des Gehäuses dadurch "angezeigt", dass eine mechanische Verbindung des Kontaktsteckers, mit welchem die elektrische Verbindung zwischen den elektronischen Komponenten des Geräts und einer anderen Komponente, z.B. einem Steuergerät, hergestellt wird, mit dem Kontaktbecher nicht möglich ist. Hierdurch wird bei der Montage des Gehäuses bereits eine mechanische, manuell fühlbare Rückkopplung gegeben. Bei einer elektrischen Funktionsprüfung können Signale der elektronischen Komponenten des Geräts nicht ausgewertet werden, da eine elektrische Steckverbindung nicht vorliegt. Damit ist die Sicherheit und die Überprüfung, ob ein Falsch-Verbau vorliegt oder nicht, beträchtlich erhöht. Darüber hinaus kann die Überprüfung hinsichtlich eines korrekten Einbaus an der vorbestimmten Position blind, das heißt ohne Sichtprüfung, erfolgen, da die Rückkopplung für einen Monteur ertastbar ist.

In einer Ausführungsform ist die Verriegelungsvorrichtung dazu ausgebildet, die Oberfläche der Anbaufläche abzutasten, um festzustellen, ob das Gehäuse mit seiner Gehäuseanbaufläche in der vorbestimmten Position an der Anbaufläche aufliegt. Zweckmäßigerweise ist die Verriegelungsvorrichtung zur mechanischen Abtastung der Anbaufläche ausgebildet. Hierdurch ergibt sich eine konstruktiv besonders einfache Ausgestaltung der Verriegelungsvorrichtung.

In einer Ausführungsform ist die Verriegelungsvorrichtung als unter Krafteinwirkung verformbare und an dem Gehäuse angeordnete Zunge nach Art eines Kragbalkens ausgebildet, die sich zwischen dem Kontaktbecher und der Gehäuseebene der Gehäuseanbaufläche erstreckt. Das Detektionsmittel und das Blockiermittel sind auf gegenüberliegenden Seiten, insbesondere an einem freien Ende, der Zunge angeordnet. Hierdurch ist es möglich, dass das Blockiermittel in Reaktion auf das Detektionsmittel arbeitet.

In einer weiteren Ausführungsform ist vorgesehen, dass die Zunge sich in einem unbelasteten Zustand befindet, wenn das Gehäuse mit seiner Gehäuseanbaufläche in der vorbestimmten Position an der Anbaufläche aufliegt, und sich in einem belasteten Zustand befindet, wenn das Gehäuse mit seiner Gehäuseanbaufläche nicht in der vorbestimmten Position an der Anbaufläche aufliegt. Aufgrund einer Krafteinwirkung, welche durch die Anbaufläche auf die Verriegelungsvorrichtung ausgeübt wird, wenn sich das Gehäuse auf der Anbaufläche befindet, erfolgt eine Verformung, welche zur Steuerung des Blockiermittels dient.

Zweckmäßigerweise ist das Detektionsmittel auf einer, der Gehäuseebene zugewandten, Seite der Zunge angeordnet und ragt im unbelasteten Zustand der Zunge über die Gehäuseebene der Gehäuseanbaufläche hinaus. Damit ist sichergestellt, dass durch das Detektionsmittel eine Verformung der Zunge herbeigeführt wird, welche ihrerseits zur Ansteuerung des Blockiermittels dient. Damit kann eine mechanische und/oder elektrische Kontaktierung des Kontaktsteckers mit dem Kontaktbecher verhindert werden. Um den Zugang zu dem Kontaktbecher freizugeben ist hingegen ein unbelasteter Zustand der Verriegelungsvorrichtung notwendig. Dieser kann dadurch herbeigeführt werden, dass eine Öffnung in der Anbaufläche vorgesehen ist, in die das Detektionsmittel eingreift, wenn das Gehäuse in der vorbestimmten Position auf der Anbaufläche aufliegt. Das Detektionsmittel übernimmt in diesem Fall auch die Funktion einer Verriegelungsvorrichtung.

Zweckmäßigerweise ist das Blockiermittel auf einer dem Kontaktbecher zugewandten Seite der Zunge angeordnet und ist im unbelasteten Zustand der Zunge außerhalb eines Steckbereichs des Kontaktsteckers gelegen, wenn der Kontaktstecker auf den Kontaktbecher aufgesteckt ist. Das Blockiermittel ist im belasteten Zustand der Zunge, wenn das Gehäuse mit seiner Gehäuseanbaufläche nicht in der vorbestimmten Position an oder auf der Anbaufläche aufliegt, innerhalb des Steckbereichs des Kontaktsteckers gelegen, so dass das Aufstecken des Kontaktsteckers auf den Kontaktbecher verhindert ist. Die physikalische Anordnung des Blockiermittels erfolgt damit in unmittelbarer Reaktion auf das Detektionsmittel.

Unter dem Steckbereich des Kontaktsteckers ist derjenige Bereich zu verstehen, der notwendig ist, um den Kontaktstecker auf den Kontaktbecher aufstecken zu können. Im Wesentlichen entspricht der Steckbereich der Dicke einer Gehäusewandung des Kontaktsteckers und damit in etwa dem Maß, welches zwischen dem Außenumfang des Kontaktbechers und dem Blockiermittel gebildet ist, wenn die Zunge im unbelasteten Zustand ist.

In einer Ausführungsform ist das Detektionsmittel als Vorsprung ausgebildet, der einen Rücken aufweist, der bezüglich der Gehäuseebene in einem Winkel angeordnet ist, wobei der Winkel derart gewählt ist, dass der Rücken im belasteten Zustand der Zunge, in dem das Gehäuse nicht in der vorbestimmten Position an der Anbaufläche aufliegt, im Wesentlichen parallel zu Gehäuseebene verläuft. Dies weist den Vorteil auf, dass das Detektionsmittel, wenn dies lateral zu der Anbaufläche bewegt wird, eine geringe Reibung verursacht.

In einer weiteren Ausführungsform ist das Blockiermittel als Vorsprung ausgebildet, der einen Rücken aufweist, der bezüglich der Gehäuseebene in einem Winkel angeordnet ist, wobei der Winkel derart gewählt ist, dass der Rücken im belasteten Zustand, in dem das Gehäuse nicht in der vorbestimmten Position an der Anbaufläche aufliegt, im Wesentlichen parallel zu Gehäuseebene verläuft. Im Ergebnis wird hierdurch eine schiefe Ebene des Rückens bereitgestellt, wenn sich das Detektionsmittel im unbelasteten Zustand befindet. Hierdurch wird das Aufstecken des Kontaktsteckers auf den Kontaktbecher erleichtert.

Vorzugsweise ist der Abstand zwischen dem Kontaktbecher und dem Blockiermittel größer als eine Gehäusedicke des Kontaktsteckers und kleiner als die Summe aus der Gehäusedicke des Kontaktsteckers und der Höhe des als Detektionsmittel dienenden Vorsprungs. Ein Vorteil dieser Variante besteht darin, dass ein Lösen des Gehäuses von der Anbaufläche verhindert wird, solange der Kontaktstecker aufgesteckt bleibt. Damit ist ein Lösen gegenüber der vorbestimmten Position von der vorbestimmten Position des Gehäuses nicht mehr möglich, sobald der Kontaktstecker auf dem Kontaktbecher aufgesteckt ist.

Die Breite der Verriegelungsvorrichtung ist in einer zweckmäßigen Ausführungsform parallel zu der Gehäuseebene derart, dass eine Verformung parallel zu der Gehäuseebene nicht möglich ist. Die Breite der Verriegelungsvorrichtung kann dabei in etwa der Breite des Kontaktbechers entsprechen.

In einer weiteren zweckmäßigen Ausführungsform weist der Außenumfang der Gehäuseanbaufläche eine im Wesentlichen trapez- oder keilförmige Gestalt auf. Die Verjüngung erfolgt bevorzugt in Richtung des Kontaktbechers hin. Hierdurch ist eine Montage über einen lateralen Einschub in einen Anschlag der Anbaufläche, welche einen Umbug aufweist, möglich. Der Anschlag stellt eine Art Führung dar, in welche das Gehäuse einschiebbar ist, bis die vorbestimmte Position erreicht ist.

Eine weitere Ausführungsform sieht vor, dass sich von der Gehäuseanbaufläche zumindest ein als Endanschlag dienender Vorsprung in orthogonaler Richtung zu der Gehäuseebene der Gehäuseanbaufläche erstreckt. Dieser übernimmt ebenfalls die Aufgabe einer Führung, wodurch das leichtere Positionieren des Gehäuses an der Anbaufläche bis zum Erreichen der vorbestimmten Position möglich ist.

Es ist weiter bevorzugt, wenn das Gehäuse und die Verriegelungsvorrichtung aus einem spritzfähigen Kunststoff gebildet sind und die Verriegelungsvorrichtung integraler Bestandteil des Gehäuses ist.

Die Erfindung wird nachfolgend anhand eines Ausführungsbeispiels in den Zeichnungen näher erläutert. Es zeigen:
- Fig. 1A-1C: ein erfindungsgemäßes Gehäuse für ein Sensormodul in einer Seitenansicht, Draufsicht und Frontalansicht;
- Fig. 2: eine Draufsicht auf eine Anbaufläche, auf welcher das erfindungsgemäße Gehäuse zu befestigen ist;
- Fig. 3: eine Schnittdarstellung eines erfindungsgemäßen Gehäuses, das auf einer Anbaufläche außerhalb seiner vorbestimmten Position angeordnet ist;
- Fig. 4A-4C: eine Seitenansicht, eine Draufsicht und eine Frontalansicht auf das auf der Anbaufläche aufgesetzte Gehäuse, wobei sich dieses nicht in seiner vorbestimmten Position befindet;
- Fig. 5: einen Schnitt durch ein erfindungsgemäßes Gehäuse, das auf einer Anbaufläche angeordnet ist und sich in einer vorbestimmten Position befindet; und
- Fig. 6A-6C: eine Seitenansicht, eine Draufsicht und eine Frontalansicht auf das erfindungsgemäße Gehäuse, das sich in der vorbestimmten Position auf der Anbaufläche befindet.

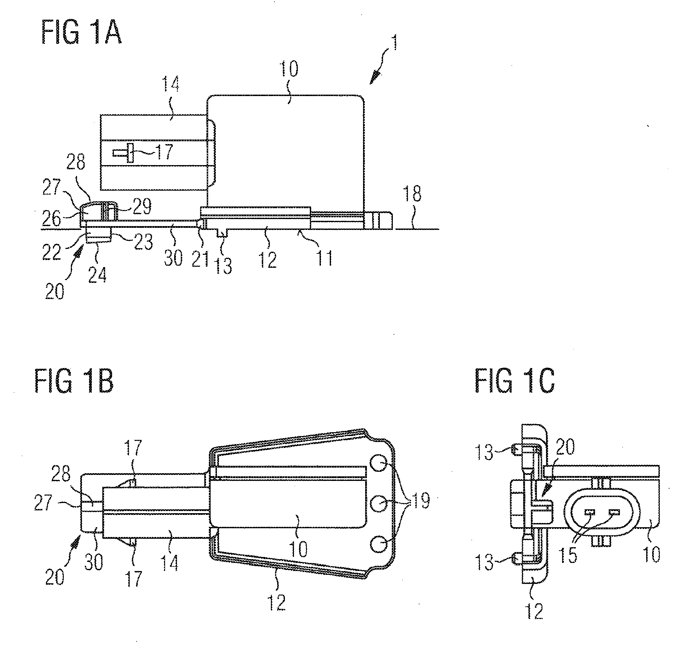

In der Darstellung der Fig. 1A bis 1C ist ein erfindungsgemäßes Gehäuse 10 für ein Sensormodul 1 in einer Seitenansicht, einer Draufsicht und einer Frontalansicht dargestellt. Bei dem Sensormodul 1 kann es sich beispielsweise um einen so genannten Seitenairbag-Satellitensensor handeln. Im Inneren des Gehäuses und aus den Figuren nicht ersichtlich, sind auf einer Platine eine Mehrzahl an elektronischen Komponenten und ein Sensor zur Erfassung einer Beschleunigung, eines Körperschallsignals oder dergleichen, angeordnet. Da die Ausgestaltung des Sensormoduls und die dazu notwendigen elektronischen Komponenten für die vorliegende Erfindung nicht von Bedeutung sind, wird an dieser Stelle auf eine ausführliche Beschreibung verzichtet. Grundsätzlich lässt sich das erfindungsgemäße Gehäuse 10 für jede beliebige Art von elektronischer Schaltung oder jedes beliebige elektronische Gerät einsetzen, bei welchem eine genaue Positionierung auf einer Anbaufläche notwendig ist.

Das Gehäuse 10 weist einen Kontaktbecher 14 auf, der in bekannter Weise Kontaktstifte 15 umfasst. Im Ausführungsbeispiel sind zwei Kontaktstifte 15 dargestellt, wobei dies lediglich beispielhaft ist. Der Kontaktbecher 14 erstreckt sich parallel zu einer Gehäuseebene 18. In der Gehäuseebene 18 ist eine Gehäuseanbaufläche 11 des Gehäuses gelegen. Das Gehäuse 10 wird mit der Gehäuseanbaufläche 11 an der später beschriebenen Anbaufläche montiert. An dem Kontaktbecher 14 sind ferner zwei gegenüberliegend angeordnete Vorsprünge 17 vorgesehen. Diese sind, wie dies aus der nachfolgenden Beschreibung deutlich werden wird, für die Montage mit einem Kontaktstecker erforderlich, wobei die Vorsprünge 17 als Widerhaken oder Anschlag für den Kontaktstecker dienen. Die Gestalt der Vorsprünge 17 ist in der Draufsicht (Fig. 1B) in etwa flügelförmig.

Zwischen dem Kontaktbecher 14 und der Gehäuseebene 18 erstreckt sich eine Verriegelungsvorrichtung 20. Die Verriegelungsvorrichtung 20 ist als eine unter Krafteinwirkung verformbare und an dem Gehäuse angeordnete Zunge 30 nach Art eines Kragbalkens ausgebildet. Die Zunge 30 ist an einem Auflager 21, welches oberhalb der Gehäuseebene 18 angeordnet ist, mit dem Gehäuse 10 verbunden.

Bevorzugt sind das Gehäuse 10 und die Verriegelungsvorrichtung 20 einstückig und integral aus einem spritzfähigen Kunststoff gebildet.

Die Zunge 30 erstreckt sich im Wesentlichen parallel zu der Gehäuseebene 18 über das Ende des Kontaktbechers 14 hinaus. An dem von dem Auflager 21 abgewandten Ende der Zunge 30 sind auf gegenüberliegenden Seiten der Zunge 30 zwei Vorsprünge 22 und 26 angeordnet. Der Vorsprung 22, der auf der der Gehäuseebene 18 zugewandten Seite der Zunge 30 angeordnet ist, stellt ein Detektionsmittel dar, das sich im unbelasteten Zustand der Zunge über die Gehäuseebene 18 hinaus erstreckt. Dies ist in Fig. 1A gut zu erkennen. Der dem Kontaktbecher 14 zugewandte Vorsprung 26 stellt ein Blockiermittel dar.

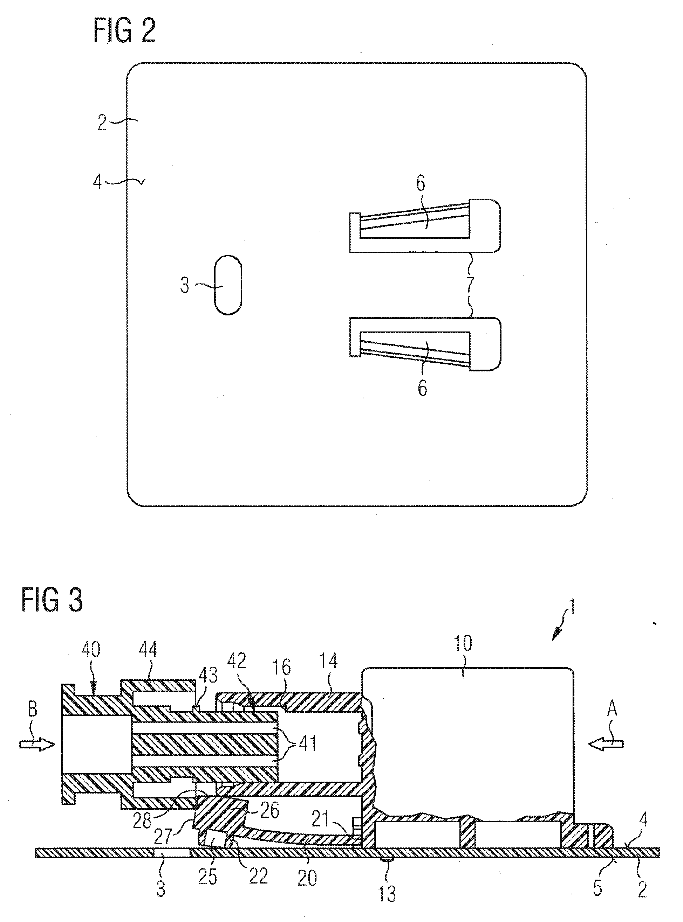

Das hohl ausgebildete (vgl. Bezugszeichen 25 in Fig. 3) Detektionsmittel 22 weist einen Rücken 24 auf, der in einem spitzen Winkel relativ zu der Gehäuseebene 18 angeordnet ist. Die schräge Anordnung des Rückens 24 dient dazu, wenn die Zunge 30 belastet ist, eine im Wesentlichen parallele Ausrichtung zu der Gehäuseebene 18 bereitzustellen. Ferner hat das Detektionsmittel 22 eine Eingriffsfläche 23, die, wie aus der nachfolgenden Beschreibung der Figuren ersichtlich werden wird, eine Verriegelung des Gehäuses 10 mit der Anbaufläche ermöglicht, wenn das Gehäuse 10 in der vorbestimmten Position auf der Anbaufläche angeordnet ist.

Das Blockiermittel 26 weist eine Eingriffsfläche 27 auf, die senkrecht zur Gehäuseebene 18 und außerhalb des Kontaktbechers 14 angeordnet ist. Die Eingriffsfläche 27 ist in einem Steckbereich des Kontaktsteckers 14 angeordnet, wenn die Zunge 30 sich in einem belasteten Zustand befindet. Ein Rücken 28 ist relativ zu der Gehäuseebene 18 ebenfalls in einem spitzen Winkel angeordnet. Befindet sich die Zunge 30 in dem in Fig. 1A gezeigten unbelasteten Zustand, so wird das Aufstecken des Kontaktsteckers auf den Kontaktbecher 14 erleichtert. Für eine erhöhte Stabilität sind an dem Blockiermittel 26 ferner zwei gegenüberliegende flanschförmige Abschnitte 29 vorgesehen.

Die Breite der Zunge 30 ist derart bemessen, dass eine laterale Auslenkung, das heißt eine Auslenkung parallel zu der Gehäuseebene 18 nicht möglich ist. Die Breite der Zunge 30 entspricht deshalb im Ausführungsbeispiel in etwa der Breite des Kontaktbechers 14, was gut aus den Fig. 1B und 1C ersichtlich ist.

An dem Gehäuse 10 sind ferner beispielhaft drei Öffnungen 19 ausgebildet, welche zur Aufnahme von Kodierzapfen dienen (vgl. Fig. 1B). Anhand der Kodierzapfen kann z.B. die Art und/oder Anordnung des Sensors für die Montage gekennzeichnet werden.

Aus Fig. 1B geht weiterhin gut die keil- oder trapezförmige Gestalt des Umfangs der Gehäuseanbaufläche hervor (Bezugszeichen 12).

An der Unterseite des Gehäuses 10 sind zwei als Endanschläge und Führungen dienende Vorsprünge 13 ausgebildet (siehe Fig. 1A und 1C), die aus der Gehäuseanbaufläche herausragen.

Die keil- oder trapezförmige Gestaltung des Umfangs der Gehäuseanbaufläche hängt mit der Art der Befestigung des Gehäuses 10 des Sensormoduls 1 auf der Anbaufläche zusammen. In Fig. 2 ist beispielhaft eine Draufsicht auf eine Anbaufläche 2 dargestellt. Erkennbar sind zwei gegenüberliegend angeordnete Anschläge 6, die jeweils einen Umbug aufweisen, die einander zugewandt sind. Im Bereich der Anschläge sind Öffnungen 7 vorgesehen, welche in Eingriff mit den zwei an der Unterseite des Gehäuses 10 ausgebildeten Endanschlägen 13 kommen. Wie ohne weiteres zu erkennen ist, sind die Anschläge 6 in einem Winkel zueinander angeordnet, welcher an die Umfangsgestalt der Gehäuseanbaufläche 12 angepasst ist. Die Anbaufläche 2 weist weiterhin eine Öffnung 3 auf, in welche das Detektionsmittel 22 einrastet, sobald das Gehäuse 10 seine vorbestimmte Position auf der Anbaufläche 2 erreicht hat.

Das Zusammenspiel des erfindungsgemäßen Gehäuses mit der beschriebenen Anbaufläche 2 wird nachfolgend besser aus den Fig. 2 bis 6 ersichtlich.

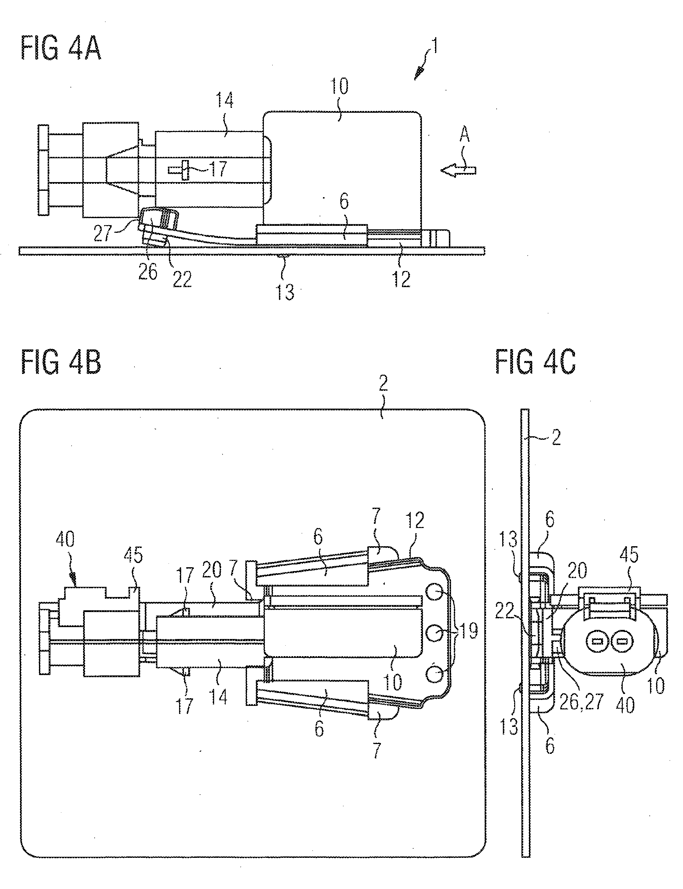

Die Fig. 3 und 4A bis 4C zeigen dabei eine Situation, in welcher das Gehäuse 10 auf der Anbaufläche 2 aufliegt, wobei die vorbestimmte Position noch nicht erreicht ist. Fig. 3 zeigt dabei einen Schnitt durch das gebildete System, während die Fig. 4A, 4B und 4C jeweils eine Seitenansicht, eine Draufsicht sowie eine Frontalansicht darstellen.

Mit dem Bezugszeichen A ist eine Bewegungsrichtung des Gehäuses 10 bezeichnet, wobei das Gehäuse 10 entlang der Anschläge 6 der Anbaufläche 2 in Richtung seiner vorbestimmten Position geschoben werden muss.

Mit dem Bezugszeichen B ist die Bewegungsrichtung des Kontaktsteckers 40 bezeichnet, welche zur mechanischen und elektrischen Kontaktierung des Kontaktbechers 14 vollzogen wird.

Aufgrund des über die Gehäuseebene 18, in welcher die Gehäuseanbaufläche 11 gelegen ist, hinausragenden Detektionsmittel 22 ergibt sich eine Belastung der Verriegelungsvorrichtung 20 in Richtung des Kontaktbechers 14. Dabei liegt der Rücken 24 des Detektionsmittels 22 im Wesentlichen vollflächig auf der Anbaufläche 2 auf. Der Rücken 28 des Blockiermittels 26 wird in Richtung des Kontaktbechers 14 gedrückt, wobei diese dabei in Kontakt geraten können. Dabei schiebt sich die Eingriffsfläche 27 in einen Steckbereich. Dadurch ist einem Kontaktstecker 40 der Zugang zu dem Kontaktbecher 14 verwehrt, so dass eine mechanische und elektrische Kontaktierung von Kontaktbecher 14 und Kontaktstecker 40 nicht bestimmungsgemäß möglich ist.

Der Kontaktstecker 40 weist einen Steckerabschnitt 42 mit Hohlleitern 41 auf, in welche die Kontaktstifte 15 des Kontaktbechers 14 eingeführt werden müssen. Der Steckerabschnitt 42 kann aufgrund des im Steckbereich liegenden Blockiermittels nicht vollständig in dem Kontaktbecher 14 eingeschoben werden. Die Eingriffsfläche 27 des Blockiermittels 26 wirkt als Anschlag und damit als mechanische Sperre für den Kontaktstecker 40.

Der Kontaktstecker 40 weist weiterhin einen Codierzapfen 43 auf, welcher seitlich an dem Steckerabschnitt 42 gebildet ist. Der Codierzapfen 43, der an einer Schulter 16 im Inneren des Kontaktbechers 14 zum Anschlag kommen kann, dient als Verdrehsicherung. Damit ist sichergestellt, dass der Kontaktstecker 40 nur in einer bestimmten Position in Kontakt mit dem Kontaktbecher 14 gebracht werden kann.

Ferner ist in einem hinteren Abschnitt des Kontaktsteckers ein Gehäusemantel 44 ausgebildet, welcher bei korrekter mechanischer Kontaktierung mit dem Kontaktbecher 14 den Kontaktbecher 14 umgreift, so dass mittels eines Verriegelungselements 45 eine Verriegelung mit einem der als Widerhaken bzw. Anschlag ausgebildeten Vorsprünge 17 erfolgen kann. Aus Fig. 4B ist besonders gut ersichtlich, dass das Verriegelungselement 45, das an dem Gehäusemantel 44 des Kontaktsteckers 40 ausgebildet ist, nicht in Kontakt mit den Vorsprüngen 17 an dem Kontaktbecher 14 aufgrund der Stellung des Blockiermittels 26 geraten kann.

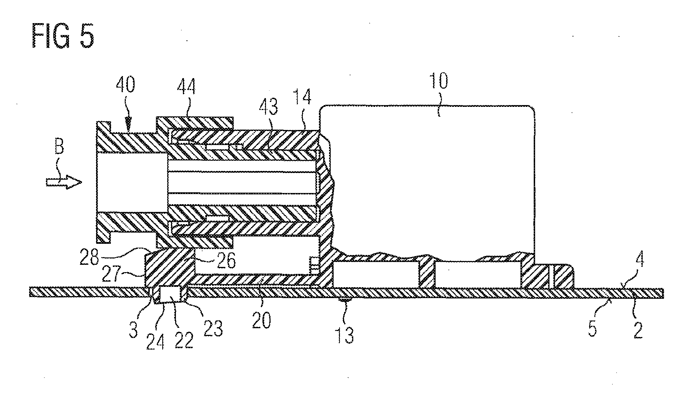

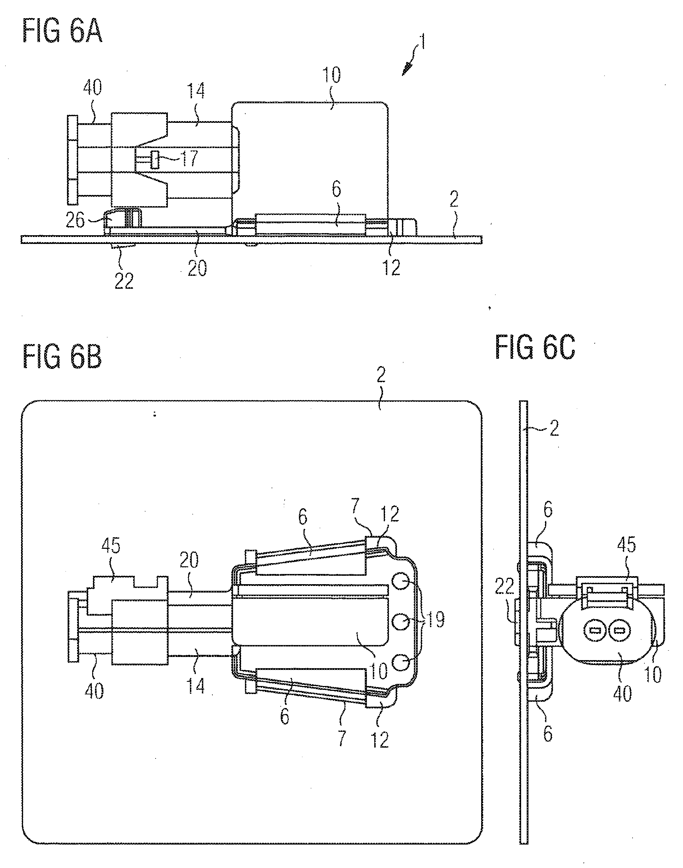

Demgegenüber zeigen die Fig. 5 und 6A bis 6C die Situation, in welcher das Gehäuse 10 in der vorbestimmten Position auf der Anbaufläche 2 angeordnet ist, so dass eine mechanische und elektrische Kontaktierung zwischen Kontaktstecker 40 und Kontaktbecher 14 bzw. den darin ausgebildeten elektrischen Leitern erfolgen kann.

Wie am besten aus Fig. 5 hervorgeht, greift das Detektionsmittel 22 in die Öffnung 3 der Anbaufläche 2 ein. Hierdurch entsteht zwischen dem Blockiermittel 26 und dem Kontaktbecher 14 genug Raum (oben als Steckbereich bezeichnet), so dass der Kontaktstecker 40 auf den Kontaktbecher 14 aufsteckbar ist. Der Abstand zwischen dem Blockiermittel 26 und dem Außenumfang des Kontaktbechers 14 ist dabei derart gewählt, dass ein geringer Spalt zwischen dem Blockiermittel 26 und dem Außenumfang des Gehäusemantels 44 entsteht. Der schräge Rücken 28 erleichtert dabei die Führung und das Aufstecken des Kontaktsteckers 40 auf den Kontaktbecher 14. Durch die gewählten Maße dient das Detektionsmittel 22 nun, da eine Eingriffsfläche 23 mit der Umrandung der Öffnung 3 in Eingriff steht, als Verriegelungsvorrichtung für das Gehäuse 10. Ein Ablösen des Gehäuses 10 von der Anbaufläche 2 ist nicht möglich, solange der Kontaktstecker 40 auf dem Kontaktbecher 14 aufgesteckt ist.

Um den Falsch-Verbau eines Gehäuses für ein elektrisches Gerät zu vermeiden und den Einbau so einfach und sicher wie möglich zu gestalten, schlägt die Erfindung vor, an dem Gehäuse einen Verriegelungsmechanismus für den Kontaktstecker in Form eines Schnapphakens auszubilden. Dieser ist bevorzugt einstückig und integral an dem Gehäuse mit ausgebildet, so dass zusätzliche Teile- und Montagekosten entfallen.

Solange das Gehäuse nicht in seiner vorbestimmten Position (Endlage) montiert ist, steht die als Schnapphaken ausgebildete Verriegelungsvorrichtung hoch und blockiert das Aufstecken des Kontaktsteckers. Ein elektrischer Kontakt zwischen dem Gerät und einem zentralen Steuergerät ist dann nicht möglich, was im Rahmen einer Funktionsprüfung detektierbar ist.

Befindet sich das Gehäuse jedoch in seiner korrekten, vorbestimmten Position (Endlage), dann rastet die als Haken ausgebildete Verriegelungsvorrichtung ein und gibt den Zugang für das Aufstecken des Kontaktsteckers frei. Ist der Kontaktstecker aufgesteckt, blockiert dieser wiederum den Verriegelungsmechanismus, der sich dann nicht mehr öffnen lässt. Damit ist eine Demontage des Gehäuses von der Anbaufläche nicht möglich, ohne vorher den Kontaktstecker gelöst zu haben.

## Patentansprüche

1. Gehäuse (10) für ein an einer Anbaufläche (2) zu befestigendes Gerät, insbesondere ein Sensormodul mit einem Sensor für ein Kraftfahrzeug, mit
a. einer Gehäuseanbaufläche (11), mit welcher das Gehäuse (10) an der Anbaufläche (2) in Anlage bringbar ist,
b. einem Kontaktbecher (14) mit elektrischen Kontaktmitteln, der mit einem komplementär ausgebildeten Kontaktstecker (40) mechanisch und elektrisch verbindbar ist und der sich parallel zu einer Gehäuseebene (18) erstreckt, in der die Gehäuseanbaufläche (11) angeordnet ist, und
c. einer Verriegelungsvorrichtung (20), wobei die Verriegelungsvorrichtung (20) aufweist
c1. ein Detektionsmittel (22), das dazu ausgebildet ist, eine vorbestimmte Position an der Anbaufläche (2) zu detektieren, wenn das Gehäuse (10) mit der Gehäuseanbaufläche (11) an der Anbaufläche (2) aufliegt, und
c2. ein Blockiermittel (26), das dazu ausgebildet ist, die mechanische und/oder elektrische Verbindung zwischen dem Kontaktbecher (14) und dem Kontaktstecker (40) freizugeben oder zu blockieren,
d. wobei das Blockiermittel (26) die mechanische und/oder elektrische Verbindung freigibt, wenn das Detektionsmittel (22) detektiert, dass das Gehäuse (10) mit seiner Gehäuseanbaufläche (11) in der vorbestimmten Position an der Anbaufläche (2) aufliegt, bzw.
e. das Blockiermittel (26) die mechanische und/oder elektrische Verbindung blockiert, wenn das Detektionsmittel (22) detektiert, dass das Gehäuse (10) mit seiner Gehäuseanbaufläche (11) nicht in der vorbestimmten Position an der Anbaufläche (2) aufliegt.

2. Gerätegehäuse nach Anspruch 1,
**dadurch gekennzeichnet, dass** die Verriegelungsvorrichtung (22) dazu ausgebildet ist, die Oberfläche der Anbaufläche (2) abzutasten, um festzustellen, ob das Gehäuse (10) mit seiner Gehäuseanbaufläche (11) in der vorbestimmten Position an der Anbaufläche (2) aufliegt.

3. Gerätegehäuse nach Anspruch 2,
**dadurch gekennzeichnet, dass** die Verriegelungsvorrichtung (22) zur mechanischen Abtastung der Anbaufläche (2) ausgebildet ist.

4. Gerätegehäuse nach einem der vorherigen Ansprüche, **dadurch gekennzeichnet, dass** die Verriegelungsvorrichtung (22) als unter Krafteinwirkung verformbare und an dem Gehäuse (10) angeordnete Zunge (30) nach Art eines Kragbalkens ausgebildet ist, die sich zwischen dem Kontaktbecher (14) und der Gehäuseebene (18) der Gehäuseanbaufläche (11) erstreckt.

5. Gerätegehäuse nach Anspruch 4,
**dadurch gekennzeichnet, dass** das Detektionsmittel (22) und das Blockiermittel (26) auf gegenüberliegenden Seiten, insbesondere an einem freien Ende, der Zunge (30) angeordnet sind.

6. Gerätegehäuse nach Anspruch 4 oder 5,
**dadurch gekennzeichnet, dass** die Zunge (30)
- sich in einem unbelasteten Zustand befindet, wenn das Gehäuse (10) mit seiner Gehäuseanbaufläche (11) in der vorbestimmten Position an der Anbaufläche (2) aufliegt, und
- sich in einem belasteten Zustand befindet, wenn das Gehäuse (10) mit seiner Gehäuseanbaufläche (11) nicht in der vorbestimmten Position an der Anbaufläche (2) aufliegt.

7. Gerätegehäuse nach Anspruch 6,
**dadurch gekennzeichnet, dass** das Detektionsmittel (22) auf einer, der Gehäuseebene (18) zugewandten, Seite der Zunge (30) angeordnet ist und im unbelasteten Zustand der Zunge (30) über die Gehäuseebene (18) der Gehäuseanbaufläche (11) hinausragt.

8. Gerätegehäuse nach Anspruch 6 oder 7,
**dadurch gekennzeichnet, dass** das Blockiermittel (26) auf einer, dem Kontaktbecher (14) zugewandten, Seite der Zunge (30) angeordnet ist und
- im unbelasteten Zustand der Zunge (30) außerhalb eines Steckbereichs des Kontaktsteckers (40) gelegen ist, wenn der Kontaktstecker (40) auf den Kontaktbecher (14) aufgesteckt ist, und
- im belasteten Zustand der Zunge (30), wenn das Gehäuse (10) mit seiner Gehäuseanbaufläche (11) nicht in der vorbestimmten Position an oder auf der Anbaufläche (2) aufliegt, innerhalb des Steckbereichs des Kontaktsteckers (40) gelegen ist, so dass das Aufstecken des Kontaktsteckers (40) auf den Kontaktbecher (14) verhindert ist.

9. Gerätegehäuse nach einem der vorherigen Ansprüche,
**dadurch gekennzeichnet, dass** das Detektionsmittel (22) als Vorsprung ausgebildet ist, der einen Rücken (24) aufweist, der bezüglich der Gehäuseebene (18) in einem Winkel angeordnet ist, wobei der Winkel derart gewählt ist, dass der Rücken (24) im belasteten Zustand der Zunge (30), in dem das Gehäuse (10) nicht in der vorbestimmten Position an der Anbaufläche (2) aufliegt, im Wesentlichen parallel zu Gehäuseebene (18) verläuft.

10. Gerätegehäuse nach einem der vorherigen Ansprüche,
**dadurch gekennzeichnet, dass** das Blockiermittel (26) als Vorsprung ausgebildet ist, der einen Rücken (28) aufweist, der bezüglich der Gehäuseebene (18) in einem Winkel angeordnet ist, wobei der Winkel derart gewählt ist, dass der Rücken (28) im belasteten Zustand, in dem das Gehäuse (10) nicht in der vorbestimmten Position an der Anbaufläche (2) aufliegt, im Wesentlichen parallel zu Gehäuseebene (18) verläuft.

11. Gerätegehäuse nach Anspruch 9,
**dadurch gekennzeichnet, dass** der Abstand zwischen dem Kontaktbecher (14) und dem Blockiermittel (26) größer als eine Gehäusedicke des Kontaktsteckers (40) und kleiner als die Summe aus der Gehäusedicke des Kontaktsteckers (40) und der Höhe des als Detektionsmittel (22) dienenden Vorsprungs ist.

12. Gerätegehäuse nach einem der vorherigen Ansprüche,
**dadurch gekennzeichnet, dass** die Breite der Verriegelungsvorrichtung (22), parallel zu der Gehäuseebene (18), derart ist, dass eine Verformung parallel zu der Gehäuseebene (18) nicht möglich ist.

13. Gerätegehäuse nach einem der vorherigen Ansprüche,
**dadurch gekennzeichnet, dass** der Außenumfang der Gehäuseanbaufläche (11) eine im Wesentlichen trapez- oder keilförmige Gestalt aufweist.

14. Gerätegehäuse nach einem der vorherigen Ansprüche,
**dadurch gekennzeichnet, dass** sich von der Gehäuseanbaufläche (11) zumindest ein als Endanschlag (13) dienender Vorsprung in orthogonaler Richtung zu der Gehäuseebene (18) der Gehäuseanbaufläche (11) erstreckt.

15. Gerätegehäuse nach einem der vorherigen Ansprüche,
**dadurch gekennzeichnet, dass** das Gehäuse (10) und die Verriegelungsvorrichtung aus einem spritzfähigen Kunststoff gebildet sind und die Verriegelungsvorrichtung (22) integraler Bestandteil des Gehäuses (2) ist.

## Claims

1. Housing (10) for a device for mounting on an assembly surface (2), in particular a sensor module comprising a sensor for a motor vehicle, with
a. a housing assembly surface (11), by means of which the housing (10) may be brought into contact with the assembly surface (2),
b. a contact socket (14) with electrical contacts which may be mechanically and electrically connected to a complementary contact plug (40) and run parallel to a housing plane (18) in which the housing assembly surface (11) is arranged, and
c. a locking device (22) wherein the locking device (20) comprises
c1. a detector means (22) designed to detect a given position on the assembly surface (2) when the housing (10) is in contact with the assembly surface (2) by means of the housing assembly surface (11) and/or
c2. a blocking means (26) designed to release or block the mechanical and/or electrical connection between the contact socket (14) and the contact plug (40),
d. wherein the blocking means (26) releases the mechanical and/or electrical connection when the detector means (22) detects that the housing (10) is in contact with the given position on the assembly surface (2) by means of housing assembly surface (11) thereof and/or
e. the blocking means (26) blocks the mechanical and/or electrical connection when the detector means (22) detects that the housing (10) is not in contact with the given position on the assembly surface (2) by means of the housing assembly surface (11) thereof.

2. Device housing according to claim 1,
**characterised in that**
the locking device (22) is designed to scan the surface of the assembly surface (2) in order to determine whether the housing (10) is in contact with the given position on the assembly surface (2) by means of the housing assembly surface (11) thereof.

3. Device housing according to claim 2,
**characterised in that**
the locking device (22) is designed for the mechanical scanning of the assembly surface (2).

4. Device housing according to any one of the preceding claims,
**characterised in that**
the locking device (22) is designed as a tongue (30) which is deformable under the action of force and arranged on the housing (10) as a type of cantilever arm extending between the contact socket (14) and the housing plane (18) of the housing assembly surface (11).

5. Device housing according to claim 4,
**characterised in that**
the detector means (22) and the blocking means (26) are arranged on opposing sides, in particular on a free end, of the tongue (30).

6. Device housing according to claim 4 or 5,
**characterised in that**
the tongue (30)
- is in an unloaded condition when the housing (10) is in contact with the given position on the assembly surface (2) by means of the housing assembly surface (11) thereof and
- is in a loaded condition when the housing (10) is not in contact with the given position on the assembly surface (2) by means of the housing assembly surface (11) thereof.

7. Device housing according to claim 6,
**characterised in that**
the detector means (22) is arranged on a side of the tongue (30) facing the housing plane (18) and in unloaded condition of the tongue (30) protrudes over the housing plane (18) of the housing assembly surface (11).

8. Device housing according to claim 6 or 7,
**characterised in that**
the blocking means (26) is arranged on a side of the tongue (30) facing the contact socket (14) and
- in unloaded condition of the tongue (30) is arranged outside a plug-in area of the contact plug (40) when the contact plug (40) is plugged onto contact socket (14), and
- in loaded condition of the tongue (30) when the housing (10) is not in contact with the given position on the assembly surface (2) by means of the housing assembly surface (11) thereof is arranged inside the plug-in area of the contact plug (40) so that the contact plug (40) cannot be plugged onto the contact socket (14).

9. Device housing according to any one of the preceding claims,
**characterised in that**
the detector means (22) is embodied as a projection having a back (24) arranged at angle with respect to the housing plane (18) with the angle being selected in such a way that the back (24) in loaded condition of the tongue (30), in which the housing (10) is not in contact with the given position on the assembly surface (2) runs substantially parallel to the housing plane (18).

10. Device housing according to any one of the preceding claims,
**characterised in that**
the blocking means (26) is embodied as a projection having a back (28) which is arranged at an angle with respect to the housing plane (18), with the angle being selected in such a way that the back (28) in loaded condition in which the housing (10) is not in contact with the given position on the assembly surface (2) runs substantially parallel to the housing plane (18).

11. Device housing according to claim 9,
**characterised in that**
the distance between the contact socket (14) and the blocking means (26) is greater than a housing thickness of the contact plug (40) and smaller than the sum of the housing thickness of the contact plug (40) and the height of the projection serving as the detector means (22).

12. Device housing according to any one of the preceding claims,
**characterised in that**
the width of the locking device (22), parallel to the housing plane (18), is such that deformation parallel to the housing plane (18) is not possible.

13. Device housing according to any one of the preceding claims,
**characterised in that**
the circumference of the housing assembly surface (11) has a substantially trapezoidal or wedge-shaped shape.

14. Device housing according to any one of the preceding claims,
**characterised in that**
at least one projection serving as an end stop (13) runs from the housing assembly surface (11) in the orthogonal direction to the housing plane (18) of the housing assembly surface (11).

15. Device housing according to any one of the preceding claims,
**characterised in that**
the housing (10) and the locking device are formed from a moldable plastic and the locking device (22) is an integral component of the housing (2).

## Revendications

1. Coffret (10) pour un appareil à fixer contre une surface de montage (2), notamment un module de capteur avec un capteur pour un véhicule automobile, comprenant
a. une surface de montage de coffret (11), avec laquelle le coffret (10) peut être mis en butée contre la surface de montage (2),
b. un boîtier de contact (14) avec des moyens de contact électriques, qui peut être relié mécaniquement et électriquement à une prise de contact (40) configurée de manière complémentaire et qui s'étend parallèlement à un plan de coffret (18) dans lequel la surface de montage de coffret (11) est agencée, et
c. un dispositif de verrouillage (20), dans lequel le dispositif de verrouillage (20) présente
c1. un moyen de détection (22), qui est conçu pour détecter une position prédéterminée contre la surface de montage (2) lorsque le coffret (10) repose contre la surface de montage (2) avec la surface de montage de coffret (11), et
c2. un moyen de blocage (26), qui est conçu pour libérer ou pour bloquer la liaison mécanique et/ou électrique entre le boîtier de contact (14) et la prise de contact (40),
d. dans lequel le moyen de blocage (26) libère la liaison mécanique et/ou électrique lorsque le moyen de détection (22) détecte que le coffret (10) repose avec sa surface de montage de coffret (11) à la position prédéterminée contre la surface de montage (2), ou
e. le moyen de blocage (26) bloque la liaison mécanique et/ou électrique lorsque le moyen de détection (22) détecte que le coffret (10) ne repose pas avec sa surface de montage de coffret (11) à la position prédéterminée contre la surface de montage (2).

2. Coffret d'appareil selon la revendication 1, **caractérisé en ce que** le dispositif de verrouillage (22) est configuré pour balayer la surface de la surface de montage (2) afin de déceler si le coffret (10) repose avec sa surface de montage de coffret (11) à la position prédéterminée contre la surface de montage (2).

3. Coffret d'appareil selon la revendication 2, **caractérisé en ce que** le dispositif de verrouillage (22) est conçu pour le balayage mécanique de la surface de montage (2).

4. Coffret d'appareil selon l'une quelconque des revendications précédentes, **caractérisé en ce que** le dispositif de verrouillage (22) est configuré sous la forme d'une languette (30), du type d'une barre en porte-à-faux, déformable sous l'effet d'une force et agencée contre le coffret (10), qui s'étend entre le boîtier de contact (14) et le plan de coffret (18) de la surface de montage de coffret (11).

5. Coffret d'appareil selon la revendication 4, **caractérisé en ce que** le moyen de détection (22) et le moyen de blocage (26) sont agencés sur des côtés opposés, notamment à une extrémité libre, de la languette (30).

6. Coffret d'appareil selon la revendication 4 ou 5, **caractérisé en ce que** la languette (30)
- se trouve dans un état non chargé lorsque le coffret (10) repose avec sa surface de montage de coffret (11) à la position prédéterminée contre la surface de montage (2), et
- se trouve dans un état chargé lorsque le coffret (10) ne repose pas avec sa surface de montage de coffret (11) à la position prédéterminée contre la surface de montage (2).

7. Coffret d'appareil selon la revendication 6, **caractérisé en ce que** le moyen de détection (22) est agencé sur un côté de la languette (30) orienté vers le plan de coffret (18) et, dans l'état non chargé de la languette (30), dépasse par dessus le plan de coffret (18) de la surface de montage de coffret (11).

8. Coffret d'appareil selon la revendication 6 ou 7, **caractérisé en ce que** le moyen de blocage (26) est agencé sur un côté de la languette (30) orienté vers le boîtier de contact (14) et
- dans l'état non chargé de la languette (30), est situé à l'extérieur d'une zone de prise de la prise de contact (40) lorsque la prise de contact (40) est enfichée sur le boîtier de contact (14), et
- dans l'état chargé de la languette (30), lorsque le coffret (10) ne repose pas avec sa surface de montage de coffret (11) à la position prédéterminée contre ou sur la surface de montage (2), est situé à l'intérieur de la zone de prise de la prise de contact (40), de manière à empêcher l'enfichage de la prise de contact (40) sur le boîtier de contact (14).

9. Coffret d'appareil selon l'une quelconque des revendications précédentes, **caractérisé en ce que** le moyen de détection (22) est configuré sous la forme d'un épaulement qui présente un dos (24), qui est agencé à un angle par rapport au plan de coffret (18), dans lequel l'angle est choisi de manière à ce que, dans l'état chargé de la languette (30), dans lequel le coffret (10) ne repose pas à la position prédéterminée contre la surface de montage (2), le dos (24) s'étale sensiblement en parallèle par rapport au plan de coffret (18).

10. Coffret d'appareil selon l'une quelconque des revendications précédentes, **caractérisé en ce que** le moyen de blocage (26) est configuré sous la forme d'un épaulement qui présente un dos (28), qui est agencé à un angle par rapport au plan de coffret (18), dans lequel l'angle est choisi de manière à ce que, dans l'état chargé, dans lequel le coffret (10) ne repose pas à la position prédéterminée sur la surface de montage (2), le dos (28) s'étale sensiblement en parallèle par rapport au plan de coffret (18).

11. Coffret d'appareil selon la revendication 9, **caractérisé en ce que** la distance entre le boîtier de contact (14) et le moyen de blocage (26) est supérieure à une épaisseur de coffret de la prise de contact (40) et inférieure à la somme de l'épaisseur de coffret de la prise de contact (40) et de la hauteur de l'épaulement servant de moyen de détection (22).

12. Coffret d'appareil selon l'une quelconque des revendications précédentes, **caractérisé en ce que** la largeur du dispositif de verrouillage (22), parallèle au plan de coffret (18), est telle qu'une déformation parallèle au plan de coffret (18) ne soit pas possible.

13. Coffret d'appareil selon l'une quelconque des revendications précédentes, **caractérisé en ce que** la périphérie extérieure de la surface de montage de coffret (11) présente une configuration essentiellement trapézoïdale ou cunéiforme.

14. Coffret d'appareil selon l'une quelconque des revendications précédentes, **caractérisé en ce qu'**au moins un épaulement servant de butée d'extrémité (13) s'étend à partir de la surface de montage de coffret (11) dans la direction orthogonale par rapport au plan de coffret (18) de la surface de montage de coffret (11).

15. Coffret d'appareil selon l'une quelconque des revendications précédentes, **caractérisé en ce que** le coffret (10) et le dispositif de verrouillage sont conçus dans un plastique injectable, et le dispositif de verrouillage (22) est un élément intégral du coffret (2).
